(19) Europäisches Patentamt

European Patent Office

Office européen des brevets

(11) **EP 1 591 553 A1**

(12) **EUROPEAN PATENT APPLICATION**

(43) Date of publication:
**02.11.2005 Bulletin 2005/44**

(51) Int Cl.7: **C23C 14/06**, H01G 9/045

(21) Application number: **04010077.8**

(22) Date of filing: **28.04.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(71) Applicant: **Becromal S.p.A.**
**I-20089 Quinto de' Stampi Rozzano (MI) (IT)**

(72) Inventors:
• **Casarico, ALberto**
**20125 Milano (IT)**

• **Chiavarotti, Giovanni Pietro**
**20152 Milano (IT)**

(74) Representative: **KEIL & SCHAAFHAUSEN**
**Patentanwälte**
**Cronstettenstrasse 66**
**60322 Frankfurt am Main (DE)**

Remarks:
Amended claims in accordance with Rule 86 (2) EPC.

(54) **Process for producing an electrode coated with titanium nitride**

(57) The present invention is directed to a process for producing an electrode, in particular a current collector electrode for capacitors, supercapacitors, batteries or the like, comprising a substrate and at least one conductive layer, in which the surface of the substrate is purified and subsequently a layer of titanium nitride is vapor deposited on the surface of the substrate, wherein the vapor deposition is effected by exposing the substrate to a plasma comprising a reactive atmosphere of ionized nitrogen with or without argon or hydrogen and evaporated titanium, and, wherein the titanium vapor is generated by means of an electric arc. Furthermore, the present invention relates to an electrode obtainable by this process as well as to the use thereof.

EP 1 591 553 A1

## Description

The present invention relates to a process for producing an electrode, in particular a current collector electrode for capacitors, supercapacitors, batteries or the like, comprising a substrate and at least one conductive layer, to an electrode obtainable by this process as well as to the use thereof.

It is known in the field of electrolytic capacitors to use metal foils as cathodes. Usually the metal foils are chemically or electrochemically etched in order to increase the surface of the metal foil and thereby increasing the specific capacity of the foil. Due to the etching of the foil the electrical resistance e.g. of an aluminium foil is increased by a certain factor in comparison to the non-etched foil, wherein the quantity of this factor depends on the amount of metal removed during the etching process. However, due to the removal of metal during the etching the mechanical strength of the metal foil decreases correspondingly.

Therefore, a couple of alternative processes for increasing the surface of metal foils were suggested making no use of chemical or electrochemical etching.

EP 0 974 989 A1 discloses a process for increasing the capacity of electrodes suitable for capacitors and the like, in which the metal foil is firstly immersed in a solution containing graphite and subsequently dried at elevated temperatures. Furthermore, EP 0 966 008 A2 suggests a method for producing an anode by creating a porous layer with an increased surface roughness on an aluminum foil as a substrate in a vacuum comprising vapor deposition of an alloy comprising aluminum and a valve metal, such as titanium, tantalum, zirconium or the like, in different process steps under different angles of incidence. Additionally, a process making use of the deposition of a layer consisting of metallic titanium on a metal foil for increasing the surface roughness is known from EP 1 122 751 A1.

However, each of the aforementioned processes provides the disadvantage that either it is expensive, the resulting electrodes have an unsatisfactorily high electrical resistance, the deposit layer is unsatisfactorily adhered to the substrate or the deposit layer is unsatisfactorily inhomogeneous.

US 6,201,685 discloses a process for coating a metal foil with thin layers of metal carbide, metal boride or metal nitride, such as titanium nitride, wherein the deposition is effected by reactive sputtering, conventional sputtering, reactive evaporation or by means of molecular beams. A disadvantage of these processes is, however, that the stoichiometry and quantity of the metal nitride, metal carbide or metal boride deposited on the substrate strongly depends on the pressure of the atmosphere used for the deposition so that the process is difficult to control. In addition, the adhesion of the deposit layer to the substrate is capable of improvement.

Therefore it is the object of the present invention to provide a process for producing an electrode comprising a substrate and at least one conductive layer, which overcome the aforementioned drawbacks as well as to provide an electrode with an excellent minimal electrical resistance, whose deposit layer is excellently adhered to the substrate.

This object is solved by the present invention by providing a process for producing an electrode, in particular a current collector electrode for capacitors, supercapacitors, batteries or the like, comprising a substrate and at least one conductive layer, in which the surface of the substrate is purified and subsequently a layer of titanium nitride is vapor deposited on the surface of the substrate, wherein the vapor deposition is effected by exposing the substrate to a plasma comprising a reactive atmosphere of ionized nitrogen with or without argon or hydrogen and evaporated titanium, and, wherein the titanium vapor is generated by means of an electric arc. Surprisingly, this process provide, compared to the processes known in the prior art using conventional sputtering, reactive sputtering or the like for the deposition of the coating layer, higher evaporation rates thus allowing the deposition of conductive layers of titanium nitride with greater thickness on the substrate. Furthermore, the present invention bases on the surprising finding that electrodes obtainable with this process provide an excellent adhesion of the deposit layer of titanium nitride on the substrate and with a better uniformity of the deposit layer in terms of the constancy of the chemical composition of the deposit layer. In addition to this, the process according to the present invention is easy to control since the quantity of titanium nitride deposited on the substrate is not very depending of the pressure of the plasma in the evaporation chamber. Consequently, this process allows to control the quantity and stoichiometry of the titanium nitride ($Ti_xN_y$) deposited on the substrate simply by adjusting the electrical process parameters accordingly. In particular, it allows to adjust the stoichiometry of the titanium nitride layer within a large range, namely to every single value of $Ti_xN_y$ with x between 0,5 and 2 and y between 0,1 and 2.

In order to evaporate titanium, a momentaneous or, preferably, a continuous electric arc may be generated by means of opposite electrodes with the titanium source connected to the negative pole.

Preferably, the arc voltage lies between 10 and 200 volt, whereas the bias voltage is adjusted to a value between 40 and 300 volt.

Good results will be obtained if the evaporation of titanium is effected in a vacuum chamber with the pressure in the chamber during the evaporation adjusted between 0,1 and 50 Pa.

Under the action of the electric arc metallic titanium evaporates from the titanium source as well as titanium cationes are emitted from the source thus forming a plasma cloud comprising, aside the reactive atmosphere, titanium atoms, electrons and positively charged titanium ions. The presence of plasma in the chamber supports a reaction between metallic titanium and molecular nitrogen in the plasma itself as well as on the substrate surface. The substrate is polarized more negatively than the cathode, which is used for the generation of the electric arc, during the deposition step in order to attract the titanium ions from the plasma onto the surface of the substrate.

According to the present invention, the reactive atmosphere consists of or comprises molecular nitrogen. In principle, any inert gas, e.g. noble gas, can be employed together with molecular nitrogen. Particular good results are obtained with a reactive atmosphere consisting of molecular ionized nitrogen and argon, preferably with a nitrogen content of between 90 and 100 % (v/v). Apart from stabilizing the arc discharge duration, a mixture of molecular ionized nitrogen and argon as reactive atmosphere has the advantage of keeping the evaporation rate constant so that the quantity of $Ti_xN_y$ deposited on the substrate is also constant. Furthermore, it is a surprising finding of the present invention that the ratio between molecular ionized nitrogen and argon in the reaction mixture has influence on the stoichiometry and structure of the titanium nitride deposit layer. More preferably, a mixture of molecular ionized nitrogen and molecular ionized hydrogen is used as reactive atmosphere, most preferably with a nitrogen content of between 80 an 100 % (v/v), since those mixtures results in electrodes with a particular excellent adhesion of the deposit layer of titanium nitride on the substrate. Furthermore, such a mixture destroys the oxide layer on aluminium as substrate due to its deoxidizing properties of the hydrogen.

In principle, the substrate may be of any material known in the art for this purpose, such as a isolation foil made of a plastic material with a conductive coating or the like. However, an aluminium foil, more preferably with a purity of between 98 and 99,99%, is preferred as substrate. Advantageous results are obtained if the thickness of the substrate lies between 15 and 100 μm and/or the conductive layer provides a thickness of between 0,1 and 10 μm.

According to a preferred embodiment of the present invention the temperature of the substrate is adjusted to a value between 20 and 300°C during exposure of the substrate to the plasma.

While the layer of titanium nitride may be vapor deposited only on one sides of the substrate a deposition on both sides of the substrate is preferred.

A further subject of the present invention is an electrode, in particular a current collector electrode for capacitors, supercapacitors, batteries or the like, providing a substrate, onto whose purified surface a layer of titanium nitride is deposited, and, which is obtainable with the aforementioned process.

Preferably, the substrate is an aluminium foil, more preferably with a purity of between 98 and 99,99%. However, it is also possible to use a substrate in form of foils, plates or the like made of other materials, such as other metals as aluminium or non-conductive materials providing a metallic surface layer.

These electrodes are characterized by an excellent adhesion of the deposit layer of titanium nitride on the substrate and an excellent uniformity of the deposit layer in terms of the constancy of the chemical composition of the deposit layer. Preferably, the titanium nitride has a stoichiometry according to the following general formula:

$$Ti_xN_y,$$

wherein x is a number between 0,5 and 2 and y lies between 0,1 and 2.

Since these electrodes have low electrical resistances they are suitable as current collectors for capacitors, in particular supercapacitors (ultracapacitors). Likewise, they can be used as cathodes in batteries.

**Claims**

1.　Process for producing an electrode, in particular a current collector electrode for capacitors, supercapacitors, batteries or the like, comprising a substrate and at least one conductive layer, in which the surface of the substrate is purified and subsequently a layer of titanium nitride is vapor deposited on the surface of the substrate, wherein the vapor deposition is effected by exposing the substrate to a plasma comprising a reactive atmosphere of ionized nitrogen with or without argon or hydrogen and evaporated titanium, and, wherein the titanium vapor is generated by means of an electric arc.

2.　Process according to claim 1, **characterized in that** a momentaneous or a continuous electric arc is generated by means of opposite electrodes with the titanium source connected to the negative pole.

3.　Process according to claim 2 or 1, **characterized in that** the arc voltage lies between 10 and 200 volt.

4.　Process according to any of the previous claims, **characterized in that** the bias voltage lies between 40 and 300 volt.

5.　Process according to any of the previous claims, **characterized in that** the evaporation of titanium is effected in a vacuum chamber.

6.　Process according to any of the previous claims, **characterized in that** the pressure in the chamber during the evaporation is adjusted between 0,1 and 50 Pa.

**7.** Process according to any of the previous claims, **characterized in that** the substrate during the deposition step is polarized more negatively than the cathode, which is used for the generation of the electric arc.

**8.** Process according to any of the previous claims, **characterized in that** the reactive atmosphere consists of molecular ionized nitrogen, a mixture of molecular ionized nitrogen and argon or a mixture of molecular ionized nitrogen and molecular ionized hydrogen.

**9.** Process according to any of the previous claims, **characterized in** the substrate is an aluminium foil preferably with a purity between 98 and 99,99%.

**10.** Process according to any of the previous claims, **characterized in that** the substrate provides a thickness of between 15 and 100 µm and/or the conductive layer provides a thickness of between 0,1 and 10 µm.

**11.** Process according to any of the previous claims, **characterized in that** the temperature of substrate is adjusted between 20 and 250 °C during exposure to the plasma.

**12.** Process according to any of the previous claims, **characterized in that** the layer of titanium nitride is vapor deposited on one or both sides of the substrate.

**13.** Electrode obtainable by a process according to any of claims 1 to 12.

**14.** Electrode according to claim 13, **characterized in that** the deposit layer comprise titanium nitride with a stoichiometry according to the following general formula:

$$Ti_xN_y,$$

wherein x is a number between 0,5 and 2 and y lies between 0,1 and 2.

**15.** Use of the electrode according to claim 14 as a current collector for supercapacitors.

**16.** Use of the electrode in batteries.

**Amended claims in accordance with Rule 86(2) EPC.**

**1.** Process for producing an electrode, in particular a current collector electrode for capacitors, supercapacitors, batteries or the like, comprising an aluminium foil as a substrate and at least one conductive layer, in which the surface of the substrate is purified and subsequently a layer of titanium nitride is vapor deposited on the surface of the substrate, wherein the vapor deposition is effected by exposing the substrate to a plasma comprising a reactive atmosphere of ionized nitrogen with or without argon or hydrogen and evaporated titanium, and, wherein the titanium vapor is generated by means of an electric arc.

**2.** Process according to claim 1, **characterized in that** a momentaneous or a continuous electric arc is generated by means of opposite electrodes with the titanium source connected to the negative pole.

**3.** Process according to claim 2 or 1, **characterized in that** the arc voltage lies between 10 and 200 volt.

**4.** Process according to any of the previous claims, **characterized in that** the bias voltage lies between 40 and 300 volt.

**5.** Process according to any of the previous claims, **characterized in that** the evaporation of titanium is effected in a vacuum chamber.

**6.** Process according to any of the previous claims, **characterized in that** the pressure in the chamber during the evaporation is adjusted between 0,1 and 50 Pa.

**7.** Process according to any of the previous claims, **characterized in that** the substrate during the deposition step is polarized more negatively than the cathode, which is used for the generation of the electric arc.

**8.** Process according to any of the previous claims, **characterized in that** the reactive atmosphere consists of molecular ionized nitrogen, a mixture of molecular ionized nitrogen and argon or a mixture of molecular ionized nitrogen and molecular ionized hydrogen.

**9.** Process according to any of the previous claims, **characterized in** the substrate is an aluminium foil with a purity between 98 and 99,99%.

**10.** Process according to any of the previous claims, **characterized in that** the substrate provides a thickness of between 15 and 100 µm and/or the conductive layer provides a thickness of between 0,1 and 10 µm.

**11.** Process according to any of the previous claims, **characterized in that** the temperature of substrate is adjusted between 20 and 250 °C during exposure to the plasma.

**12.** Process according to any of the previous claims, **characterized in that** the layer of titanium nitride is vapor deposited on one or both sides of the substrate.

**13.** Electrode obtainable by a process according to any of claims 1 to 12.

**14.** Electrode according to claim 13, **characterized in that** the deposit layer comprise titanium nitride with a stoichiometry according to the following general formula:

$$Ti_x N_y,$$

wherein x is a number between 0,5 and 2 and y lies between 0,1 and 2.

**15.** Use of the electrode according to claim 14 as a current collector for supercapacitors.

**16.** Use of the electrode in batteries.

**European Patent Office**

## EUROPEAN SEARCH REPORT

Application Number

EP 04 01 0077

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 905 274 A (ZAKRYTOE AKTSIONERNOE OBSCHEST) 31 March 1999 (1999-03-31) * page 5, line 5 - line 25; figures 3,4 * * page 6, line 15 - line 35 * | 1-16 | C23C14/06 H01G9/045 |
| A | US 5 234 561 A (BUSKE JEFFREY M ET AL) 10 August 1993 (1993-08-10) * column 2, line 48 - column 4, line 50 * * column 6, line 63 - column 7, line 54 * * column 9, line 61 - column 10, line 44; figure 2 * | 1-16 | |
| D,A | US 6 201 685 B1 (MIKKOR MATI ET AL) 13 March 2001 (2001-03-13) * column 1, line 8 - column 4, line 13; figure 1 * | 1-16 | |
| D,A | EP 1 122 751 A (BECROMAL SPA) 8 August 2001 (2001-08-08) * the whole document * | 1-16 | |
| A | EP 0 344 316 A (MATSUSHITA ELECTRIC IND CO LTD) 6 December 1989 (1989-12-06) * page 7, line 15 - line 30 * | 1,5,6,8 | TECHNICAL FIELDS SEARCHED (Int.Cl.7) C23C H01G |
| A | PATENT ABSTRACTS OF JAPAN vol. 1999, no. 08, 30 June 1999 (1999-06-30) & JP 11 067606 A (NIPPON CHEMICON CORP), 9 March 1999 (1999-03-09) * abstract * | 1-16 | |

The present search report has been drawn up for all claims

| Place of search | Date of completion of the search | Examiner |
|---|---|---|
| Munich | 6 October 2004 | Frias Rebelo, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
......................................................................................
& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 04 01 0077

This annex lists the patent family members relating to the patent documents cited in the above-mentioned European search report.
The members are as contained in the European Patent Office EDP file on
The European Patent Office is in no way liable for these particulars which are merely given for the purpose of information.

06-10-2004

| Patent document cited in search report | | Publication date | Patent family member(s) | | Publication date |
|---|---|---|---|---|---|
| EP 0905274 | A | 31-03-1999 | RU | 2098878 C1 | 10-12-1997 |
| | | | RU | 2087588 C1 | 20-08-1997 |
| | | | AU | 6321796 A | 22-10-1997 |
| | | | DE | 69629316 D1 | 04-09-2003 |
| | | | DE | 69629316 T2 | 27-05-2004 |
| | | | EP | 0905274 A1 | 31-03-1999 |
| | | | JP | 3475193 B2 | 08-12-2003 |
| | | | JP | 2000509101 T | 18-07-2000 |
| | | | CN | 1216074 A | 05-05-1999 |
| | | | CZ | 9803116 A3 | 16-06-1999 |
| | | | WO | 9737052 A1 | 09-10-1997 |
| US 5234561 | A | 10-08-1993 | BR | 8904290 A | 17-04-1990 |
| | | | KR | 157302 B1 | 16-11-1998 |
| US 6201685 | B1 | 13-03-2001 | WO | 0019465 A1 | 06-04-2000 |
| | | | US | 6565701 B1 | 20-05-2003 |
| EP 1122751 | A | 08-08-2001 | DE | 10005124 A1 | 23-08-2001 |
| | | | EP | 1122751 A1 | 08-08-2001 |
| EP 0344316 | A | 06-12-1989 | JP | 1033915 A | 03-02-1989 |
| | | | JP | 1033916 A | 03-02-1989 |
| | | | JP | 1033917 A | 03-02-1989 |
| | | | JP | 1033918 A | 03-02-1989 |
| | | | DE | 3852026 D1 | 08-12-1994 |
| | | | DE | 3852026 T2 | 30-03-1995 |
| | | | EP | 0344316 A1 | 06-12-1989 |
| | | | WO | 8901230 A1 | 09-02-1989 |
| | | | US | 4970626 A | 13-11-1990 |
| JP 11067606 | A | 09-03-1999 | NONE | | |

EPO FORM P0459

For more details about this annex : see Official Journal of the European Patent Office, No. 12/82

7